# EUROPEAN PATENT APPLICATION

(11) **EP 4 361 727 A1**
(43) Date of publication of application: **01.05.2024**
(21) Application number: 22203387.0
(22) Date of filing: 24.10.2022
(51) Int. Cl.: G03F 7/20

(54) **METHOD OF TILT METROLOGY AND ASSOCIATED APPARATUSES**

(71) Applicant: ASML Netherlands B.V., 5500 AH Veldhoven (NL)
(72) Inventor: ANUNCIADO, Roy, 5500 AH Veldhoven (NL); DZAFIC, Harun, 5500 AH Veldhoven (NL); RIDANE, Mohamed, 5500 AH Veldhoven (NL)
(74) Representative: ASML Netherlands B.V.

(57) **Abstract**

Disclosed is metrology method comprising: obtaining metrology data relating to a measurement of at least one target, each said at least one target comprising a plurality of features; said metrology data describing a placement error of one or more pairs of corresponding features of said at least one target, each one or more pairs of corresponding features comprising pairs of features which are substantially equidistant from a reference point on the target in a measurement direction of the target; determining an asymmetric component of said placement error from said metrology data; and determining a tilt parameter from said asymmetric component.

## Description

### FIELD OF THE INVENTION

The present invention relates to methods and apparatus for applying patterns to a substrate in a lithographic process, and more specifically inspection of such patterns once applied.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth or critical dimension (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools.

In performing lithographic processes, such as application of a pattern on a substrate or measurement of such a pattern, process control methods are used to monitor and control the process. Such process control techniques are typically performed to obtain corrections for control of the lithographic process. It would be desirable to improve such process control methods.

One important parameter relevant to proper functioning of a device (e.g., an integrated circuit) formed by such lithographic processes is referred to as tilt. Tilt refers to an unintended tilting of a vertical feature (normal to the substrate plane) with respect to the z-direction (vertical axis) in a patterned substrate. This may be a particular issue for features comprising a high aspect ratio such as, for example, contact holes. A large tilt may result in contact holes of successive layers not being properly aligned, resulting in a poor contact or even no contact.

Such process control methods typically rely on inspection or metrology of exposed patterns, e.g., using a scatterometer or scanning electron microscope. Scatterometer-based tilt metrology requires a lengthy and involved training and calibration to acquire a relationship between measurements and tilt values. Tilt metrology using an SEM is known; however, such methods require the physical tilting of the substrate, which is time-consuming, and therefore not be viable for monitoring in a high-volume manufacturing scenario.

It is desirable to improve on such tilt metrology methods.

### SUMMARY OF THE INVENTION

In a first aspect of the invention there is provided a metrology method comprising: obtaining metrology data relating to a measurement of at least one target, each said at least one target comprising a plurality of features; said metrology data describing a placement error of one or more pairs of corresponding features of said at least one target, each one or more pairs of corresponding features comprising a pair of features which are substantially equidistant from a reference point on the target in a measurement direction of the target; determining an asymmetric component of said placement error from said metrology data; and determining a tilt parameter from said asymmetric component.

In a second aspect of the invention, there is provided a computing apparatus comprising a processor, and being configured to perform the method of the first aspect.

In a third aspect of the invention, there is provided an inspection apparatus being operable to image a plurality of features on a substrate, and comprising the computing apparatus of the second aspect.

In a fourth aspect of the invention, there is provided a computer program comprising program instructions operable to perform the method of the first aspect when run on a suitable apparatus.

In a fifth aspect of the invention, there is provided a substrate comprising a target arrangement, the target arrangement comprising at least one target for measuring a tilt parameter, each said target comprising a plurality of features; wherein a spacing of the features of the target is larger between at least some features further from a center of the target with respect to features nearer the center of the target.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
Figure 1 depicts a lithographic apparatus together with other apparatuses forming a production facility for semiconductor devices;
Figure 2 illustrates a target subject to different processes, illustrating the concept underlying the proposed method;
Figure 3 is a plot of placement error against target position for a target not subject to a global tilt component and a target which is subject to a global tilt component;
Figure 4 illustrates a target arrangement according to an embodiment; and
Figure 5 illustrates a pattern for forming a target arrangement according to an embodiment.

### DETAILED DESCRIPTION

Before describing embodiments of the invention in detail, it is instructive to present an example environment in which embodiments of the present invention may be implemented.

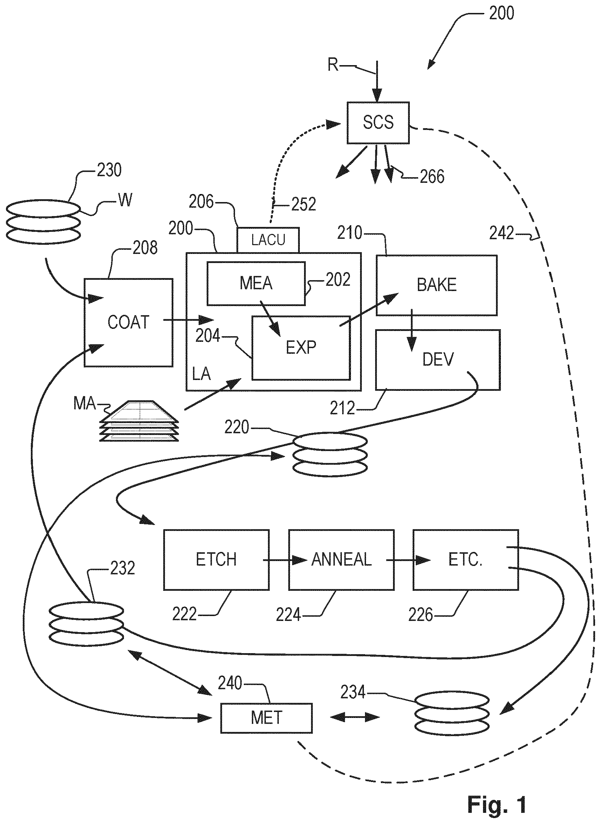

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Another example of a metrology station is a scanning electron microscope (SEM), otherwise referred to as an electron beam (e-beam) metrology device, which may be included in addition to, or as an alternative to, a scatterometer. As such, metrology apparatus 240 may comprise an e-beam or SEM metrology device, either alone or in addition to a scatterometer. SEM metrology devices have the advantage of measuring features directly (i.e., they directly image the features), rather than the indirect measurement techniques used in scatterometry (where parameter values are determined from reconstruction from and/or asymmetry in diffraction orders of radiation diffracted by the structure being measured). SEM tools scan one or more beams of electrons over a sample area to create an image of the area.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

In addition to overlay and CD, another important parameter to be monitored, at least for some devices, is that often referred to as tilt or etch tilt, i.e., the degree of tilting away from vertical (z-axis, normal to the substrate plane) of a feature such as a high aspect ratio (tall) feature. Such features may be contact holes or any other structures formed via lithography and etch. Such high aspect ratio features may be formed in so-called 3D structures for memory devices (e.g., 3D NAND). Such structures may use high aspect ratio channels or contact holes which are created by exposing an initial pattern and etching (e.g., reactive ion etch) down from the exposed pattern. Ideally, the etching should be vertical to obtain a vertical contact hole. However, for a number of reasons (e.g., due to proximity effects), the etched contact hole channel may deviate from being vertical, meaning it is tilted. Should its tilt be too great, the contact hole may fail to make contact with the structure (e.g., another contact hole) to which it is intended, resulting in a non-functioning device. Note that while this description will describe the concepts disclosed largely in terms of contact holes or etched channels, the concepts are applicable to any structure formed via a lithographic process (e.g., lithography and etch) and is subject to etch tilt.

There are a number of methods presently used for measuring etch tilt. One method uses a scatterometer to image the present structures to obtain pupil images (angularly resolved images or "pupils"). A calibration or training may be performed as an initial step to learn a mapping of these pupils to a tilt value. However this training is involved, requiring a full design of experiments analysis reducing the availability of the scanner and total throughput of the lithography fab. Another method may use a scanning electron microscope (SEM) or similar device (e.g., a transmission electron microscopy apparatus) to measure the tilt directly using a tilted beam (with respect to the substrate) during the measurement. However, such a method is typically time-consuming, which would not be viable for monitoring in a high-volume manufacturing scenario.

Following lithographic exposure, the actual locations of the printed features will be at (or very close to) their designed positions. However, after etch and in the absence of a global tilt component due to etching, a placement error (e.g., due to the proximity effect) of pairs of features equidistant (either side) in a direction of interest from a central reference will tend to be equal in magnitude but opposite in direction. As such, the outer rows of features will tend to shift outwards or inwards (process dependent) after etch; the effect of this tending to be symmetrical. However, the presence of a global tilt component will result in a measurable additional placement error. The profile of the placement error comprising this additional component will be asymmetric, especially in the outer rows. It is proposed that the global etch tilt can be quantified by measuring and calculating this asymmetric component in the placement error. By qualifying the tilt, it is possible to predict yield, and/or determine corrections for later wafers/lots (e.g., scanner and/or etcher corrections) which reduce tilt and/or mitigate for tilt (e.g., determine other positional corrections to ensure proper contact in successive layers, taking into account the determined tilt).

A metrology method is proposed which addresses the drawbacks of prior art methods such as described. The method may comprise measuring one or more targets or sets of features (e.g., one or more lines or 1D arrays of features) using a metrology device such as an SEM (or any other metrology device capable of measuring placement error) to measure placement error of one or more corresponding pairs of outer features of each set of features. The degree of tilt (a tilt parameter value) can then be determined from a difference of the placement error of respective features of one or more pairs of corresponding features (e.g., features other than a center feature assuming an odd number of features). A pair of corresponding features may comprise features that are either side of, and substantially equidistant from, a reference point such as the center of the target in a measurement direction of the target.

For example, the difference of the outermost pair of features (e.g., the difference between a placement error of a first feature of a row and last feature of a row) may be used. Alternatively, a difference between other pairs of corresponding features may be used (e.g., a pair comprising the second feature from either end of the row, a pair comprising the third feature from either end of the row etc.).

Respective differences from more than one pair of corresponding features may be averaged to determine a tilt value, or else curve asymmetry may be integrated over difference values for all pairs (or a subset thereof) of corresponding features outside of a central feature (or reference feature).

Multiple (e.g., similar) sets of features may be provided such that tilt values can be averaged over the sets to average out SEM noise.

The placement error may relate to the placement error subsequent to etch and hard mask removal, e.g., as measured using a top-down SEM measurement. This may be referenced to a reference position or intended position (e.g., with reference to a file comprising GDS (Graphic Design System) information or other reference).

The features of each set of features may be evenly spaced. Alternatively, spacing may be larger between at least some outer features with respect to inner features. For example, the spacing may increase between features from the center outwards. In this manner, asymmetry may be increased and therefore detection sensitivity may be amplified.

The relative tilt value determined from the difference may be translated into an absolute tilt value (e.g., in terms of an angle) if height or thickness data is provided (e.g., using trigonometry). Such height data may comprise at least the hard mask height (etch depth height), i.e., to determine the hard mask tilt (the actual tilt within the hard mask layer). As such, this metrology method enables measurement of the actual angle of tilt introduced by the system and therefore to modify the scanner/etcher recipe to eliminate/mitigate said fingerprint.

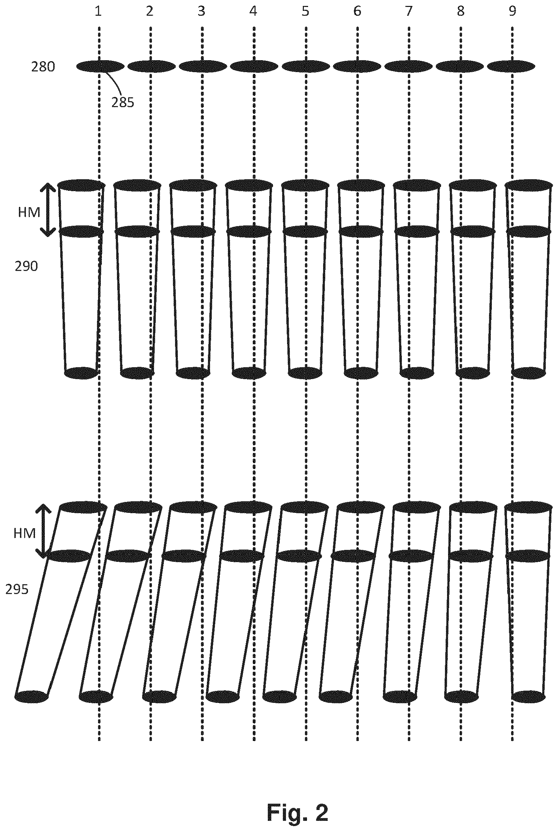

If the hard mask is being etched with the same chemistry and etcher as the feature, then the hard mask tilt will be the same as the feature tilt (tilt of the whole feature below the hard mask), and therefore the feature tilt can be extrapolated accordingly. This is the scenario illustrated in Figure 2. It may be that the hard mask is etched with a different chemistry than the feature etch, but within the same etch chamber. In this case, the hard mask tilt is still highly likely to be the same as the actual tilt of the feature, such that any difference in the tilts can be ignored. Where the hard mask is etched with a different chemistry than the feature etch, and within a different etch chamber, than it may be that the measure hard mask etch is not truly indicative of the feature etch. This is however uncommon.

The proposed set(s) of features may be comprised on a product reticle and therefore printed on production substrates. Based on measurements of a substrate exposed using such a reticle, an across-substrate tilt fingerprint can be obtained. In an embodiment, the tilt calculation may be normalized such that an across-substrate average is zero. This may be done to remove any offset which is not of interest, so as to obtain a sign-preserved tilt signal. Alternatively an absolute value may be used should the absolute degree of tilt be of interest, without its direction.

The number of rows of features in the measurement direction may be any plurality of features, however an odd number of features (i.e., three or more) is preferred. Where there is an odd number of features, the central feature or reference feature may be similar to the other features, or else may be different; e.g., larger to provide a stronger reference. Providing an odd number of rows greater than three enables the asymmetry due to tilt to be better characterized, as its relationship with distance can be better determined. This can improve the accuracy of the tilt measurement, by averaging or integrating over a greater number of measurements. The number of rows of features per target may be 5 or more, 7 or more, 9 or more, 11 or more, 13 or more, 15 or more, 17 or more or 19 or more for example.

The may be sets of features oriented in each perpendicular direction of the substrate plane (i.e., to measure tilt in both the x and y directions of a substrate coordinate system).

Figure 2 illustrates the concept behind the proposed method. The top of the figure shows a set of features, i.e., forming a target 280, as printed on a substrate (e.g., after development but prior to etching). Each feature 285 is located essentially at its intended position, the center of which is signified here by a dotted line. In the specific example shown, each feature 285 is to be a contact hole (i.e., it is an imaged pattern in resist for formation of a contact hole) and the target 280 comprises nine contact holes. However, the features may, for example, comprise lines of a line-space target or any other array of similar features.

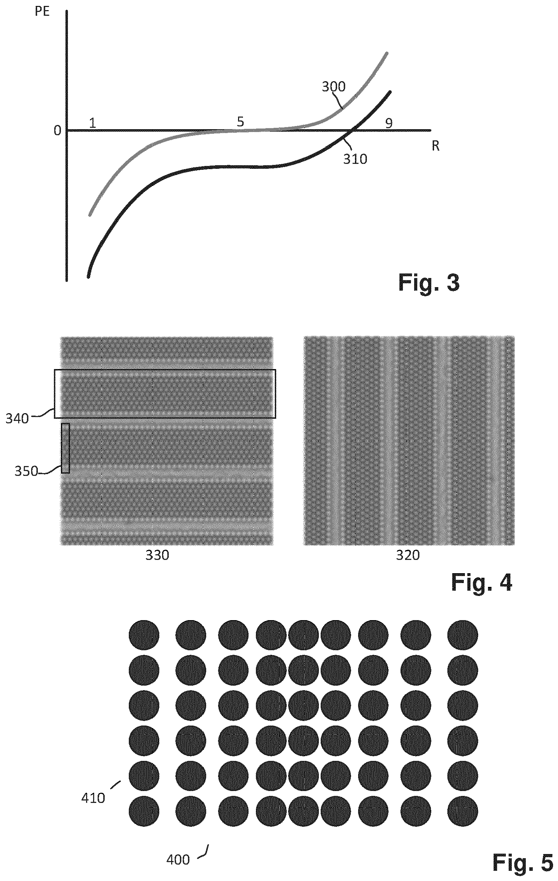

Below this, the first etched target 290 (e.g., comprising contact holes in this example) is shown for a situation in the absence of a global tilt component. First etched target 290 may be the result of performing an etching step on target 280. There is a placement error for all the features other than the center feature, with the placement error increasing from the center of the target outwards. While this displacement is shown to be fairly linear in the illustrative example, the effect is typically non-linear, with features near the center typically being subject to minimal placement error, the placement error increasing significantly away from a central region. This is illustrated in the plot 300 of Figure 3, showing placement error PE against row or position (within the target) R for such a first etched target 290 (i.e., without a global tilt component). Of particular note is that this shift or displacement error is substantially symmetrical over the target as a whole (with no placement error at the target center). As such, for example, the magnitude of the placement error of each feature of pairs of corresponding features is substantially the same. A pair of corresponding features in this context may comprise features being substantially equidistant from the target center in the measurement direction or direction of interest. As such, in first etched target 290, the feature in row 1 is displaced by the same magnitude as the feature in row 9, as are the features in rows 2 and 8 etc.. This symmetry is also apparent from plot 300 in Figure 3.

Figure 2 also shows a second etched target 295, which is an example of what may be seen when a global tilt component is present. As with first etched target 290, this second etched target 295 may be the result of performing an etching step on target 280, the difference being that a global tilt component is now present. It is this global tilt component which may be measured using the proposed method. The overall placement error is a combination of the (symmetrical over the target) placement error illustrated by the plot 300 of Figure 3 (i.e., relating to the first etched target 290) and the global tilt component. However, the global tilt component induces an asymmetric shift across the target, such that the placement error (in this specific example) has a greater magnitude for the feature row 1 than the feature in row 9. This global tilt component can be isolated from the other effects and therefore measured by taking a difference of the placement error for features either side of the target center or center feature (reference feature or feature 5 in this specific example).

In particular, a placement error difference between features of one or more pairs of corresponding features may be used. In a simplest embodiment, this may comprise taking a difference from the outermost features (e.g., the placement error from the features of rows 1 and 9 in the specific example) or another pair of corresponding features (the outermost features will show the greatest sensitivity, but any pair of corresponding features may be used. As has already been described, other methods of determining the global tilt component may be used based on any measurement or determination of asymmetry in the target including averaging or integrating asymmetry over multiple pairs of corresponding features. Figure 3 also shows a plot 310 of placement error PE against row R for such a second etched target 295 having a global tilt component. The target asymmetry is clear from this plot.

A target arrangement may comprise multiple such targets or sets of features, such that tilt determined may be averaged over the multiple targets. A target arrangement may further comprise a target or multiple targets per x and y direction. Figure 4 illustrates such a target arrangement, comprises an x-oriented region 320 and a y-oriented region 330, each region comprising one or more blocks 340 of multiple rows 350 of contact holes (e.g., once again 9 contact holes per target or row) extending in a direction perpendicular to the measurement direction. In the specific example shown, each region has multiple such blocks.

Measurement of the target may comprise measuring the position of each feature (or at least one or more pairs of corresponding features) after etch and hard mask HM removal. This can then be referenced to the respective intended position or reference position (e.g., as indicated by the dotted lines) to determine a placement error for that feature. Asymmetry over the target can then be determined from these placement errors as has been described.

If the heights of the hard mask HM is known (and optionally the height of the material underneath the hard mask until the etch-stop, the tilt can be expressed in actual angle (rather than an arbitrary delta placement error shift). This can be determined over the substrate to determine a tilt fingerprint or tilt map (across-substrate tilt distribution).

Figure 5 illustrates an exemplary target arrangement (single direction) 400 according to an embodiment. This target arrangement comprises (in this specific example) six individual targets 410, each of which comprises multiple pitches, e.g., such that a spacing of outer features is greater than a spacing of inner features. In this specific example, the pitch increases from feature-to-feature from the center of the target outwards. This amplifies the effect (asymmetric displacement) of the global tilt component, therefore increasing resolution (sensitivity) in measuring the tilt, advantageously enabling smaller displacements to be measured using the same tool.

The obtained tilt parameter values can be used to determine scanner and/or etcher (and/or other tool used in the manufacturing process) control corrections, e.g., in a feedback control loop. The tilt parameter values can also be used for monitoring and/or controlling drift of the process and/or the tools used.

The approach described herein enables auto-calibration, which saves time and gains throughput. There is no need to calibrate a designs of experiment (scatterometer) or tilt (present SEM methods). The approach can be performed inline on production substrates, to determine a tilt fingerprint introduced by the etcher or other apparatus.

Additional embodiments are disclosed in the subsequent numbered list of clauses:
1. A metrology method comprising:
   obtaining metrology data relating to a measurement of at least one target, each said at least one target comprising a plurality of features; said metrology data describing a placement error of one or more pairs of corresponding features of said at least one target, each one or more pairs of corresponding features comprising a pair of features which are substantially equidistant from a reference point on the target in a measurement direction of the target;
   determining an asymmetric component of said placement error from said metrology data; and determining a tilt parameter from said asymmetric component.
2. A metrology method as defined in clause 1, wherein said tilt parameter comprises a measure of a global tilt component in the metrology data.
3. A metrology method as defined in clause 1 or 2, wherein said determining an asymmetric component comprises:
   determining a difference value describing a difference in placement error of respective features of said one or more pairs of corresponding features.
4. A metrology method as defined in clause 3, comprising determining said difference in placement error for a plurality of pairs of corresponding features; and
   determining said tilt parameter as an average over a plurality of pairs of corresponding features.
5. A metrology method as defined in clause 3, wherein said determining an asymmetric component comprises integrating over respective difference values for a plurality of pairs of corresponding features.
6. A metrology method as defined in any preceding clause, wherein said metrology data relates to a plurality of said targets, and said method comprises an averaged tilt parameter as an average over said plurality of targets.
7. A metrology method as defined in any preceding clause, wherein said placement error relates to placement of each feature subsequent to etching and hard mask removal with respect to a respective reference position.
8. A metrology method as defined in clause 7, wherein each respective reference position comprises an intended position for that feature.
9. A metrology method as defined in any preceding clause, wherein said metrology data comprises electron microscope data.
10. A metrology method as defined in any preceding clause, wherein the features of each target are evenly spaced.
11. A metrology method as defined in any of clauses 1 to 9, wherein a spacing of the features of each target is larger between at least some features further from a center of the target with respect to features nearer the center of the target.
12. A metrology method as defined in clause 11, wherein the spacing increases between features from the center outwards.
13. A metrology method as defined in any preceding clause, comprising determining an absolute tilt value from said tilt parameter and height data relating to height of the stack and/or hard mask.
14. A metrology method as defined in any preceding clause, wherein said metrology data relates to a plurality of locations on a substrate, and the method further comprises determining an across-substrate distribution of the tilt parameter.
15. A metrology method as defined in clause 14, comprising normalizing said tilt parameter such that an across-substrate average is zero.
16. A metrology method as defined in any preceding clause, wherein said metrology data relates to said at least one target formed from a product reticle.
17. A metrology method as defined in any preceding clause, comprising using said determined tilt parameter to determine a control correction for an integrated circuit manufacturing process, in a feedback control loop.
18. A metrology method as defined in any preceding clause, wherein each said at least one target comprises a 1 dimensional array of features.
19. A metrology method as defined in any preceding clause, wherein each said at least one target comprises an odd number of features.
20. A metrology method as defined in clause 19, wherein a center feature of each said at least one target is different to the other features of each target.
21. A metrology method as defined in any preceding clause, wherein each said at least one target comprises 5 or more features.
22. A metrology method as defined in any preceding clause, wherein each said at least one target comprises 7 or more features.
23. A metrology method as defined in any preceding clause, wherein each said at least one target comprises 9 or more features.
24. A metrology method as defined in any preceding clause, comprising determining that the tilt parameter is zero if there is no asymmetric component of said placement error.
25. A metrology method as defined in any preceding clause, wherein each of said features, or at least each of said features other than a center feature of said at least one target, comprises a contact hole.
26. A metrology method as defined in any of clauses 1 to 24, wherein each of said features, or at least each of said features other than a center feature of said at least one target, comprises a line feature.
27. A metrology method as defined in any preceding clause, wherein said metrology data relates to at least one target oriented in a first direction of a substrate plane and at least one target oriented in a second direction of the substrate plane, perpendicular to said first direction; and the method comprises:
   determining said tilt parameter in said first direction and said second direction.
28. A metrology method as defined in any preceding clause, comprising measuring said at least one target to obtain said metrology data.
29. A metrology method as defined in clause 28, comprising an initial step of exposing and etching said at least one target on a substrate.
30. A metrology method as defined in any preceding clause, wherein said reference point comprises a center of the target in a measurement direction of the target.
31. A computing apparatus comprising a processor, and being configured to perform the method of any preceding clause.
32. An inspection apparatus being operable to image one or more features on a substrate, and comprising the computing apparatus of clause 31.
33. An inspection apparatus as defined in clause 32, comprising an electron microscopy inspection apparatus.
34. An inspection apparatus as defined in clause 32 or 33 comprising a scanning electron microscopy inspection apparatus or transmission electron microscopy inspection apparatus.
35. A computer program comprising program instructions operable to perform the method of any of clauses 1 to 29, when run on a suitable apparatus.
36. A non-transient computer program carrier comprising the computer program of clause 35.
37. A substrate comprising a target arrangement, the target arrangement comprising at least one target for measuring a tilt parameter, each said target comprising a plurality of features; wherein a spacing of the features of target is larger between at least some features further from a reference point of the target with respect to features nearer the reference point of the target.
38. A substrate as defined in clause 37, wherein the spacing increases between features from the center outwards.
39. A substrate as defined in clause 37 or 38, wherein each said at least one target comprises a 1 dimensional array of features.
40. A substrate as defined in any of clauses 37 to 39, wherein each said at least one target comprises an odd number of features.
41. A substrate as defined in clause 40, wherein a center feature of each said at least one target is different to the other features of each target.
42. A substrate as defined in any of clauses 37 to 41, wherein each said at least one target comprises 5 or more features.
43. A substrate as defined in any of clauses 37 to 41, wherein each said at least one target comprises 7 or more features.
44. A substrate as defined in any of clauses 37 to 41, wherein each said at least one target comprises 9 or more features.
45. A substrate as defined in any of clauses 37 to 44, wherein said target arrangement comprises at least one target oriented in a first direction of a substrate plane and at least one target oriented in a second direction of the substrate plane, perpendicular to said first direction.
46. A substrate as defined in any of clauses 37 to 45, wherein each of said features, or at least each of said features other than a center feature of said at least one target, comprises a contact hole.
47. A substrate as defined in any of clauses 37 to 45, wherein each of said features, or at least each of said features other than a center feature of said at least one target, comprises a line feature.
48. A substrate as defined in any of clauses 37 to 47, wherein said reference point comprises a center of the target in a measurement direction of the target.
49. A reticle comprising a pattern operable to pattern a substrate to obtain the substrate of any of clauses 37 to 48.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A metrology method comprising:
obtaining metrology data relating to a measurement of at least one target, each said at least one target comprising a plurality of features; said metrology data describing a placement error of one or more pairs of corresponding features of said at least one target, each one or more pairs of corresponding features comprising a pair of features which are substantially equidistant from a reference point on the target in a measurement direction of the target;
determining an asymmetric component of said placement error from said metrology data; and
determining a tilt parameter from said asymmetric component.

2. A metrology method as claimed in claim 1, wherein said determining an asymmetric component comprises:
determining a difference value describing a difference in placement error of respective features of said one or more pairs of corresponding features.

3. A metrology method as claimed in claim 1 or 2, wherein said metrology data relates to a plurality of said targets, and said method comprises an averaged tilt parameter as an average over said plurality of targets.

4. A metrology method as claimed in any preceding claim, wherein said metrology data comprises electron microscope data.

5. A metrology method as claimed in any preceding claim, wherein a spacing of the features of each target is larger between at least some features further from a center of the target with respect to features nearer the center of the target.

6. A metrology method as claimed in any preceding claim, comprising determining an absolute tilt value from said tilt parameter and height data relating to height of the stack and/or hard mask.

7. A metrology method as claimed in any preceding claim, wherein said metrology data relates to a plurality of locations on a substrate, and the method further comprises determining an across-substrate distribution of the tilt parameter.

8. A metrology method as claimed in any preceding claim, comprising using said determined tilt parameter to determine a control correction for an integrated circuit manufacturing process, in a feedback control loop.

9. A metrology method as claimed in any preceding claim, wherein each said at least one target comprises an odd number of features.

10. A metrology method as claimed in any preceding claim, wherein each said at least one target comprises 5 or more features.

11. A metrology method as claimed in any preceding claim, wherein each of said features, or at least each of said features other than a center feature of said at least one target, comprises a contact hole.

12. A metrology method as claimed in any preceding claim, wherein said metrology data relates to said at least one target formed from a product reticle.

13. An inspection apparatus being operable to image one or more features on a substrate, and comprising a computing apparatus comprising a processor, the computing apparatus being configured to perform the method of any preceding claim.

14. A computer program comprising program instructions operable to perform the method of any of claims 1 to 12, when run on a suitable apparatus.

15. A substrate comprising a target arrangement, the target arrangement comprising at least one target for measuring a tilt parameter, each said target comprising a plurality of features; wherein a spacing of the features of target is larger between at least some features further from a reference point of the target with respect to features nearer the reference point of the target.
